(19) Europäisches Patentamt
European Patent Office
Office européen des brevets

(11) **EP 4 375 696 A1**

(12) **EUROPEAN PATENT APPLICATION**
published in accordance with Art. 153(4) EPC

(43) Date of publication:
**29.05.2024 Bulletin 2024/22**

(21) Application number: **22845966.5**

(22) Date of filing: **20.07.2022**

(51) International Patent Classification (IPC):
**G01S 7/03** (2006.01)    **H05K 9/00** (2006.01)

(52) Cooperative Patent Classification (CPC):
**G01S 7/03; H05K 9/00**

(86) International application number:
**PCT/JP2022/028280**

(87) International publication number:
**WO 2023/003033 (26.01.2023 Gazette 2023/04)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **21.07.2021 JP 2021121074**

(71) Applicant: **NITTO DENKO CORPORATION**
**Ibaraki-shi**
**Osaka 567-8680 (JP)**

(72) Inventors:
• **UI Takehiro**
  **Ibaraki-shi, Osaka 567-8680 (JP)**
• **FUKE Kazuhiro**
  **Ibaraki-shi, Osaka 567-8680 (JP)**
• **MATSUZAKI Yuya**
  **Ibaraki-shi, Osaka 567-8680 (JP)**
• **AKIYAMA Kyohei**
  **Ibaraki-shi, Osaka 567-8680 (JP)**

(74) Representative: **Grünecker Patent- und Rechtsanwälte**
**PartG mbB**
**Leopoldstraße 4**
**80802 München (DE)**

(54) **ELECTROMAGNETIC WAVE SHIELD AND RADAR COVER**

(57)    An electromagnetic shield 1a includes a plate-shaped base 5 having a first surface 10 and a second surface 20. The first surface 10 is a surface configured to allow an electromagnetic wave to be incident on the first surface 10. The second surface 20 is distant from the first surface 10 and extends along the first surface 10. The electromagnetic shield 1a includes projecting strip portions 11. The electromagnetic shield 1a includes a dielectric. The electromagnetic shield 1a has a space 15 forming either a gap or a hole, and the gap or the hole is in contact with the projecting strip portion 11 along a direction intersecting with a longitudinal direction of the projecting strip portion 11.

FIG. 1

EP 4 375 696 A1

**Description**

TECHNICAL FIELD

The present invention relates to an electromagnetic shield and a radar cover.

BACKGROUND ART

Sensing systems using radio waves have been known. For example, collision avoidance systems including a radar using a radio wave with a given wavelength are under discussion in the automotive technical field. Such collision avoidance systems, for example, detect obstacles, measure the speed of nearby vehicles, measure a distance to a nearby vehicle, and adjust the speed of a vehicle equipped with the system and a vehicle-to-vehicle distance. For normal operation, it is important for a collision avoidance system not to receive unnecessary radio waves that can be noise.

Patent Literature 1 describes the use of an electromagnetic wave absorber for absorption of unnecessary electromagnetic waves that can cause a driver-assistance system to malfunction. In the electromagnetic wave absorber described in Patent Literature 1, scattering bodies made of a second dielectric material and each having a particular shape are cyclically arranged in a matrix made of a first dielectric material.

Patent Literature 2 describes a radar device attached to and supported by a rear bumper using an attaching member (refer to FIG. 8). The attaching member includes a box-shaped housing, and the housing includes a shield plate. The shield plate closes a path between a vehicle-widthwise outer side portion of the radar device and a backside of a rear bumper to block a transmission wave. The shield plate is provided as a misdetection prevention member to close a path of a tire arrival wave $\alpha$, so that misdetection is prevented. Patent Literature 2 describes a misdetection prevention member including a diffused reflection structure including irregularities in a given shape (refer to FIG. 13). It is understood that the diffused reflection structure diffusely reflects an incident wave from a radar device to disperse the energy of the incident wave, thereby preventing misdetection.

Patent Literature 3 describes an automotive radar module (refer to FIG. 7B). This automotive radar module is configured to reduce multipath effects by one or more patterned surfaces of a shield, a mounting fixing device, or a bracket.

Patent Literature 4 describes a side shield for radar transceivers. A non-uniform delay structure is arranged over the side shield. The non-uniform delay structure delays a radar signal propagating through the side shield by a variable amount depending on the wavelength of the radar signal and where in the side shield the radar signal propagates. The radar signal is thereby steered and diffused after propagation through the side shield.

CITATION LIST

Patent Literature

Patent Literature 1: JP 2004-153135 A
Patent Literature 2: JP 5696781 B2
Patent Literature 3: US 10,074,907 B2
Patent Literature 4: WO 2021/058450 A1

SUMMARY OF INVENTION

Technical Problem

Electromagnetic shielding is conceivable for prevention of reception of unnecessary radio waves. Projecting strips may be formed on a surface of an electromagnetic shield to impart an electromagnetic shielding function to the electromagnetic shield, the surface being configured to allow electromagnetic waves to be incident thereon. A situation where projecting strips are formed on a surface of an electromagnetic shield and water is on the surface is not expected in the above patent literatures, the surface being configured to allow electromagnetic waves to be incident thereon.

In view of these circumstances, the present invention provides an electromagnetic shield that is advantageous in facilitating drainage of water on a surface of the electromagnetic shield, the surface having projecting strips.

Solution to Problem

The present invention provides an electromagnetic shield including:

a plate-shaped base having a first surface and a second surface, the first surface being configured to allow an electromagnetic wave to be incident on the first surface, the second surface being distant from the first surface and extending along the first surface; and

projecting strip portions projecting from the first surface in a direction away from the second surface, wherein the electromagnetic shield includes a dielectric,

the electromagnetic shield has a space forming either a gap or a hole, and

the gap or the hole is in contact with the projecting strip portion along a direction intersecting with a longitudinal direction of the projecting strip portion.

The present invention provides a radar cover including the above electromagnetic shield.

Advantageous Effects of Invention

The above electromagnetic shield is advantageous in facilitating drainage of water on the surface configured to allow an electromagnetic wave to be incident thereon.

BRIEF DESCRIPTION OF DRAWINGS

FIG. 1 is a plan view showing an example of the electromagnetic shield according to the present invention.
FIG. 2 is a cross-sectional view showing the electromagnetic shield along a line II-II shown in FIG. 1.
FIG. 3A is a plan view of an example of the radar cover according to the present invention.
FIG. 3B is a plan view of another example of the radar cover according to the present invention.
FIG. 4 is a cross-sectional view of the radar cover along a line IV-IV shown in FIG. 3A.
FIG. 5 is a plan view of another example of the electromagnetic shield according to the present invention.
FIG. 6 is a cross-sectional view showing the electromagnetic shield along a line VI-VI shown in FIG. 5.

DESCRIPTION OF EMBODIMENTS

Hereinafter, embodiments of the present invention will be described with reference to the drawings. The present invention is not limited to the following embodiments.

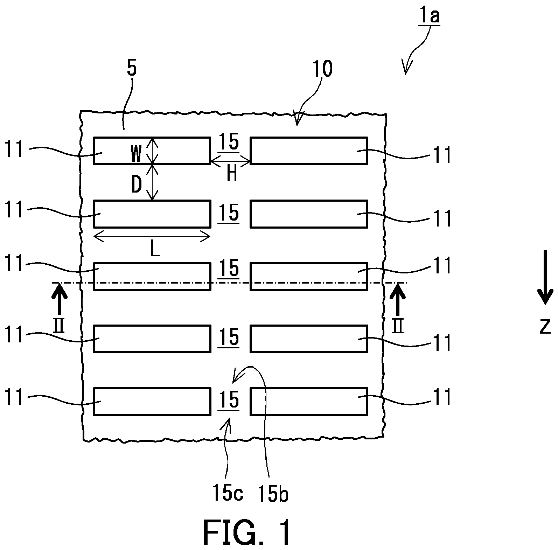

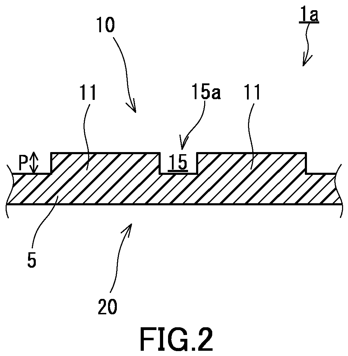

As shown in FIGS. 1 and 2, an electromagnetic shield 1a includes a plate-shaped base 5 having a first surface 10 and a second surface 20. The first surface 10 is a surface configured to allow an electromagnetic wave to be incident on the first surface 10. The second surface 20 is distant from the first surface 10 and extends along the first surface 10. The first surface 10 and the second surface 20, for example, face opposite directions. The electromagnetic shield 1a includes projecting strip portions 11. The electromagnetic shield 1a includes a dielectric. The electromagnetic shield 1a has a space 15 forming either a gap or a hole, and the gap or the hole is in contact with the projecting strip portion 11 along a direction intersecting with a longitudinal direction of the projecting strip portion 11. The term "electromagnetic shield" herein refers to an article that can exhibit a function of attenuating the energy of an electromagnetic wave. The principle on which an electromagnetic shield attenuates the energy of an electromagnetic wave is not limited to a particular principle. The principle can be, for example, one using a phenomenon, such as reflection, transmission, absorption, diffraction, or interference, accompanying an interaction between an electromagnetic wave and an electromagnetic shield and a phenomenon, such as scattering or diffusion of the electromagnetic wave, caused by the former phenomenon. When a given electromagnetic wave is incident on the first surface 10 of the electromagnetic shield 1a, the energy of the electromagnetic wave is attenuated.

The electromagnetic shield 1a may be used in an environment where water can be placed on the first surface 10 due to rainfall, washing, condensation, etc. Assuming that an electromagnetic shield having a surface with a projecting strip is disposed such that the projecting strip projects in a horizontal direction and extends along the horizontal direction, when water is placed above the projecting strip on the surface, it is likely that the projecting strip prevents drainage of the water and the water stays near the projecting strip. A permittivity exhibited near the projecting strip in the case where water stays near the projecting strip on the surface with the projecting strip is different from a permittivity exhibited near the projecting strip in the case where no water stays near the projecting strip. The permittivity near the projecting strip can be crucial for the performance of the electromagnetic shield. Therefore, water staying near the projecting strip on the surface with the projecting strip is likely to decrease the performance of the electromagnetic shield, making it difficult to attenuate a radio wave incident on the surface with the projecting strip to a desired state.

On the other hand, since the electromagnetic shield 1a has the space 15 in contact with the projecting strip portion 11, it is easy to drain water placed near the projecting strip portion 11 away through the space 15. In other words, the space 15 can function as a drainage path. Therefore, water is less likely to stay near the projecting strip portion 11, and thus the performance of the electromagnetic shield 1a is less likely to decrease.

As shown in FIG. 2, the space 15 has an opening 15a at an end of the space 15 in a projection direction of the projecting strip portion 11. In other words, the space 15 is formed as a gap. In such a configuration, the contact area between a wall abutting on the space 15 and water is likely to be decreased, and it is easier to drain water placed near the projecting strip portion 11 away through the space 15.

In the case where the space 15 is formed as a gap, the space 15 is placed, for example, between a pair of the projecting strip portions 11 arranged in the longitudinal direction of the projecting strip portion 11.

The shape and the dimensions of the space 15 are not limited to a particular embodiment. In the case where the space 15 is formed as a gap, a maximum dimension H of the space 15 in the longitudinal direction of the projecting strip portion 11 is not limited to a particular value. The maximum dimension H is, for example, more than 1 mm. In such a configuration, it is easier to drain water placed near the projecting strip portion 11 away through the space 15.

The maximum dimension H of the space 15 is desirably 1.2 mm or more, more desirably 1.5 mm or more, even more desirably 2 mm or more. The maximum dimension H is, for example 15 mm or less, desirably 12 mm or less, even more desirably 10 mm or less. In these cases, the electromagnetic shield 1a is likely to exhibit high electromagnetic shielding performance. The maximum dimension H may be 8 mm or less, 6 mm or less, 5 mm or less, or 4 mm or less.

In the case where the space 15 is formed as a gap, a cross-section of a flow path defined by the space 15 may have the shape of a rectangle, a triangle, or a figure including a curve such as an arc. A depth of the space 15 may be the same as a projection length P of the projecting strip portion 11, smaller than the projection length P, or greater than the projection length P. The depth of the space 15 is, for example, 1 mm or more, and may be 2 mm or more, 3 mm or more, or 4 mm or more.

In FIG. 1, the electromagnetic shield 1a is disposed such that the projecting strip portion 11 projects in a horizontal direction and extends along the horizontal direction. An arrow Z in FIG. 1 indicates the gravity direction. In the case of this disposition, one end 15b of the space 15 is positioned above the other end 15c of the space 15b. In such a configuration, when the electromagnetic shield 1a is disposed as described above, water placed near the projecting strip portion 11 is likely to pass the space 15 from the one end 15b toward the other end 15c by the action of gravity. Therefore, it is easier to drain water placed near the projecting strip portion 11 away through the space 15.

As shown in FIG. 1, the electromagnetic shield 1a includes, for example, a plurality of the projecting strip portions 11 arranged parallel to each other. Additionally, the electromagnetic shield 1a has a plurality of the spaces 15. Each projecting strip portion 11 is in contact with at least one of the spaces 15. In such a configuration, it is easy to drain water placed between the projecting strip portions 11 adjacent to each other away through any of the spaces 15.

As shown in FIG. 1, the electromagnetic shield 1a includes a pair of the projecting strip portions 11 arranged in the longitudinal direction of the projecting strip portion 11, and the space 15 may be present between the pair of projecting strip portions 11.

The projecting strip portions 11 are, for example, in a row in a direction perpendicular to the longitudinal direction of the projecting strip portion 11. In this case, a distance D between the projecting strip portions 11 adjacent to each other in the direction perpendicular to the longitudinal direction of the projecting strip portion 11 is not limited to a particular value. The distance D is, for example, greater than the maximum dimension H of the space 15 in the longitudinal direction of the projecting strip portion 11. In such a configuration, water placed between the projecting strip portions 11 adjacent to each other is less likely to stay between the projecting strip portions 11.

A length L of the projecting strip portion 11 in the longitudinal direction of the projecting strip portion 11 is not limited to a particular value. The length L is, for example, 100 mm or less. In such a configuration, a distance that water placed near the projecting strip portion 11 travels to be led to the space 15 tends to be shorter, and water placed near the projecting strip portion 11 is likely to drain away in a short period of time.

The length L may be 95 mm or less, 90 mm or less, 75 mm or less, 60 mm or less, or 50 mm or less. The length L is, for example 5 mm or more, and may be 10 mm or more, or 15 mm or more. The length L may be 100 mm or more.

In the electromagnetic shield 1a, arrangement of the spaces 15 is not limited to particular arrangement. As shown in FIG. 1, the spaces 15 are arranged, for example, on a straight line. In such a configuration, water passing one of the spaces 15 is likely to be directly led down to another space 15, and water placed on the first surface 10 is likely to drain away in a short period of time. The spaces 15 may be arranged at different positions in the longitudinal direction of the projecting strip portion 11.

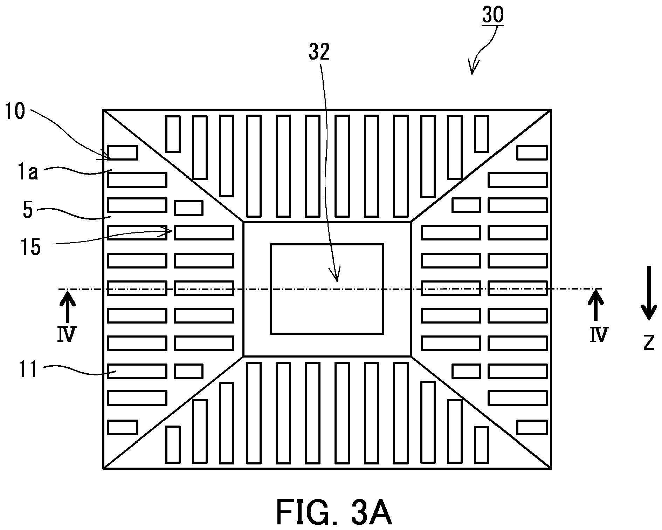

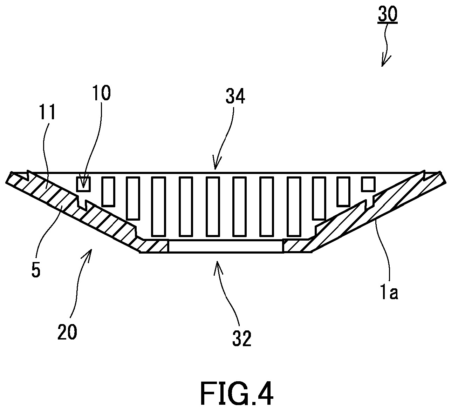

The shapes of the electromagnetic shield 1a and the base 5 are not limited to particular shapes. As shown in FIGS. 3A and 4, at least one selected from the group consisting of the electromagnetic shield 1a and the base 5 is, for example, a ring-shaped body and has a polygonal or circular outer perimeter when the first surface 10 is viewed along an axis of the ring-shaped body. In such a configuration, an electromagnetic wave incident on the first surface 10 through a space surrounded by at least one selected from the group consisting of the electromagnetic shield 1a and the base 5 can be blocked.

As shown in FIGS. 3A and 4, an outer shape of at least one of selected from the group consisting the electromagnetic shield 1a and the base 5 is, for example, a truncated pyramidal shape. At least one selected from the group consisting of the electromagnetic shield 1a and the base 5 is, for example, a hollow body and has an opening in each of positions in the outer shape, the positions corresponding to an upper base and a lower base of a truncated pyramid. At least one selected from the group consisting of the electromagnetic shield 1a and the base 5 has, for example, a first opening 32 in a position corresponding to the upper base of a truncated pyramid and a second opening 34 in a position corresponding to the lower base thereof. The first surface 10 is an inner surface of the hollow body being the electromagnetic shield 1a or the base 5. The second surface 20 is an outer surface of the hollow body being the electromagnetic shield 1a or the base 5. In such a configuration, electromagnetic shielding by the electromagnetic shield 1a can be achieved in a larger space. Furthermore, the first opening 32 of the electromagnetic shield 1a can be used to dispose therein an antenna for transmission and reception of an electromagnetic wave. The outer shape of at least one selected from the group consisting of the electromagnetic shield 1a and the base 5 may be a truncated conical shape or a truncated elliptical conical shape. In this case, the electromagnetic shield 1a has an opening in each of positions in the outer shape, the positions corresponding to the upper base and the lower base of a truncated cone or a truncated elliptic cone.

The projecting strip portions 11 project, for example, in a direction perpendicular to the lower base of a truncated pyramid, a truncated cone, or a truncated elliptic cone being the outer shape of the electromagnetic shield 1a or the base 5. In such a configuration, the electromagnetic shield 1a is likely to have even higher electromagnetic shielding performance. Moreover, such a configuration is advantageous in manufacturing, for example, in that the electromagnetic shield 1a made by injection molding can be released from a simple mold without a structure such as a slide core.

The projecting strip portion 11 may have a draft angle toward a direction away from the base 5. A corner portion of the projecting strip portion 11 may be formed of a curved surface having a given curvature radius. Such a configuration is desirable, for example, in manufacturing the electromagnetic shield 1a by injection molding from the viewpoint of release of a molded article from a mold.

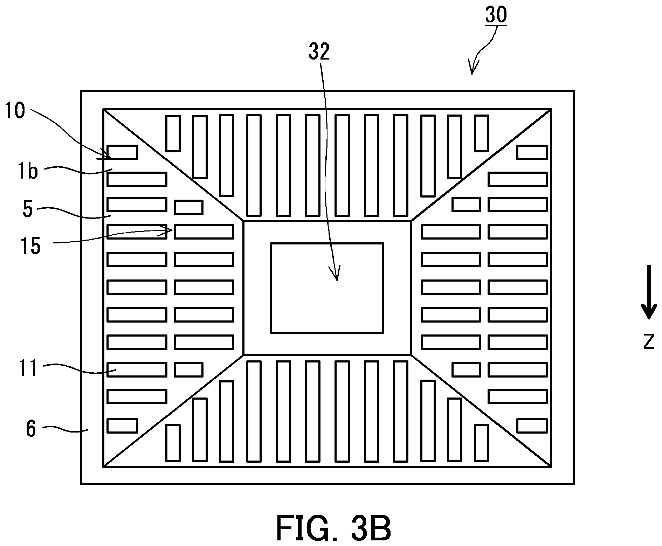

The electromagnetic shield 1a may be modified to an electromagnetic shield 1b as shown in FIG. 3B. The electromagnetic shield 1b is configured in the same manner as the electromagnetic shield 1a unless otherwise described. The electromagnetic shield 1b includes a contact portion 6. The contact portion 6 is a portion configured to be in contact with a component other than the electromagnetic shield 1b. The contact portion 6 abuts on a polygonal or circular outer perimeter seen when the first surface 10 is viewed along the axis of the electromagnetic shield 1b or the base 5 having a ring shape. With such a configuration, the electromagnetic shield 1b can be attached to another component with the contact portion 6 in contact with the other component. The contact portion 6 forms, for example, a flange.

The electromagnetic shield 1a can be used, for example, as an electromagnetic shield for millimeter-wave radars, millimeter-wave radio communication, millimeter-wave sensing, or the like. A device including the electromagnetic shield 1a can be used, for example, in automobiles and wireless base stations. When the electromagnetic shield 1a is for millimeter-wave radars, the electromagnetic shield 1a can be included in a millimeter-wave radar using one frequency band selected from the group consisting of the 24 GHz band, the 60 GHz band, the 76 GHz band, and the 79 GHz band. The electromagnetic shield 1a is not just for blocking only an electromagnetic wave with a particular wavelength, and may block electromagnetic waves in a wide wavelength region. It is also possible to regard an electromagnetic wave with a particular wavelength $\lambda$ as a "shielding target" of the electromagnetic shield 1a. For example, in the case of the electromagnetic shield installed with a vehicle-mounted millimeter-wave radar configured to irradiate an object with an electromagnetic wave practically having frequencies of 76 to 77 GHz, i.e., having practical irradiation wavelengths of 3.89 to 3.94 mm, 3.92 mm which is the wavelength of the center frequency, 76.5 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 77 to 81 GHz, i.e., using an electromagnetic wave having wavelengths of 3.70 to 3.89 mm, 3.79 mm, which is the wavelength of the center frequency, 79 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 24.05 to 24.25 GHz, i.e., using an electromagnetic wave having wavelengths of 12.36 to 12.47 mm, 12.41 mm, which is the wavelength of the center frequency, 24.15 GHz, can be understood as the wavelength $\lambda$, namely, the shielding target of this electromagnetic shield. In the case where the electromagnetic shield is for millimeter-wave radars using an electromagnetic wave having frequencies of 60.0 to 60.1 GHz, i.e., using an electromagnetic wave having wavelengths of 4.99 to 5.00 mm, 4.99 mm, which is the wavelength of the center frequency, 60.05 GHz, can be understood as the wavelength $\lambda$, namely, the shielding target of this electromagnetic shield. In the case where the electromagnetic shield is for millimeter-wave radio communication using an electromagnetic wave having frequencies of 27 to 29.5 GHz, i.e., using an electromagnetic wave having wavelengths of 10.16 to 11.10 mm, 10.61 mm, which is the wavelength of the center frequency, 28.25 GHz, can be understood as the wavelength $\lambda$, namely, the shielding target of this electromagnetic shield. In the case where the electromagnetic shield is, for example, sold with a label saying that its supporting frequencies are 70 to 90 GHz, i.e., its supporting wavelengths are 3.33 to 4.28 mm, 3.75 mm, which is the wavelength of the center frequency, 80 GHz, can be understood as the wavelength $\lambda$, namely, the shielding target of this electromagnetic shield.

In the electromagnetic shield 1a, the projection length P of the projecting strip portion 11 is not limited to a particular value. When the particular wavelength λ, namely, the shielding target of the electromagnetic shield 1a and the projection length P are compared, the projection length P is, for example, 0.25λ or more. This allows the electromagnetic shield 1a to block an electromagnetic wave in a more desired state. The projection length P is desirably 0.51λ or more, and more desirably 0.77λ or more. The projection length P is, for example, 5.1λ or less, and may be 3.5λ or less, or 3.0λ or less.

In the electromagnetic shield 1a, the projection length P of at least one of the projecting strip portions 11 desirably satisfies a requirement 0.25λ ≤ P ≤ 1.3λ. In this case, the electromagnetic shield 1a is likely to have even higher electromagnetic shielding performance.

When the requirement 0.25λ ≤ P ≤ 1.3λ is satisfied, the projection length P may be 0.30λ or more, 0.35λ or more, 0.40λ or more, 0.45λ or more, or 0.50λ or more. The projection length P may be 1.2λ or less, 1.1λ or less, 1.0λ or less, or 0.9λ or less.

Fifty percent or more of the projecting strip portions 11 on a number basis satisfy, for example, the requirement 0.25λ ≤ P ≤ 1.3λ. Sixty percent or more of the projecting strip portions 11 on a number basis may satisfy the requirement 0.25λ ≤ P ≤ 1.3λ. Seventy percent or more of the projecting strip portions 11 on a number basis may satisfy the requirement 0.25λ ≤ P ≤ 1.3λ. Eighty percent or more of the projecting strip portions 11 on a number basis may satisfy the requirement 0.25λ ≤ P ≤ 1.3λ. Ninety percent or more of the projecting strip portions 11 on a number basis may satisfy the requirement 0.25λ ≤ P ≤ 1.3λ. All projecting strip portions 11 may satisfy the requirement 0.25λ ≤ P ≤ 1.3λ.

A width W of the projecting strip portion 11 is not limited to a particular value. When the particular wavelength λ, namely, the shielding target of the electromagnetic shield 1a and the width W are compared, the width W is, for example, 0.12λ or more. This allows the electromagnetic shield 1a to block an electromagnetic wave in a more desired state. The width W is desirably 0.25λ or more, more desirably 0.51λ or more. The width W is, for example, 5.1λ or less, and may be 3.5λ or less, or 3.0λ or less. The width W is a dimension of the projecting strip portion 11 in a direction perpendicular to the longitudinal and projecting directions of the projecting strip portion 11.

In the electromagnetic shield 1a, the width W of at least one of the projecting strip portions 11 desirably satisfies a requirement 0.51 λ ≤ W ≤ 1.6λ. In this case, the electromagnetic shield 1a is likely to have even higher electromagnetic shielding performance.

When the requirement 0.51λ ≤ W ≤ 1.6λ is satisfied, the width W may be 0.55λ or more, 0.60λ or more, 0.65λ or more, 0.70λ or more, or 0.75λ or more. The width W may be 1.5λ or less, 1.4λ or less, 1.3λ or less, 1.2λ or less, 1.1 λ or less, or 1.0λ or less.

Fifty percent or more of the projecting strip portions 11 on a number basis satisfy, for example, the requirement 0.51λ ≤ W ≤ 1.6λ. Sixty percent or more of the projecting strip portions 11 on a number basis may satisfy the requirement 0.51λ ≤ W ≤ 1.6λ. Seventy percent or more of the projecting strip portions 11 on a number basis may satisfy the requirement 0.51λ ≤ W ≤ 1.6λ. Eighty percent or more of the projecting strip portions 11 on a number basis may satisfy the requirement 0.51 λ ≤ W ≤ 1.6λ. Ninety percent or more of the projecting strip portions 11 on a number basis may satisfy the requirement 0.51λ ≤ W ≤ 1.6λ. All projecting strip portions 11 may satisfy the requirement 0.51λ ≤ W ≤ 1.6λ.

The distance D between the projecting strip portions 11 adjacent to each other in the direction perpendicular to the longitudinal and projecting directions of the projecting strip portion 11 is not limited to a particular value. When the particular wavelength λ, namely, the shielding target of the electromagnetic shield 1a and the distance D are compared, the distance D is, for example, 5.1λ or less. This allows the electromagnetic shield 1a to block an electromagnetic wave in a more desired state. The distance D is desirably 3.10λ or less, more desirably 2.04λ or less. The distance D is, for example, 1.0λ or more, and may be 1.2λ or more, or 1.5λ or more.

In the electromagnetic shield 1a, the distance D desirably satisfies a requirement 0.51 λ ≤ D ≤ 1.6λ. In this case, the electromagnetic shield 1a is likely to have even higher electromagnetic shielding performance. When the requirement 0.51λ ≤ D ≤ 1.6λ is satisfied, the distance D may be 0.55λ or more, 0.60λ or more, 0.65λ or more, 0.70λ or more, or 0.75λ or more. The distance D may be 1.5λ or less, 1.4λ or less, or 1.3λ or less.

As shown in FIGS. 1 and 2, the electromagnetic shield 1a includes the plate-shaped base 5. In such a configuration, the projecting strip portions 11 are likely to be disposed in a desired state. Moreover, the electromagnetic shield 1a is likely to have a high mechanical strength.

A thickness of the base 5 is not limited to a particular value. The thickness of the base 5 is, for example, 0.5 mm to 3 mm. The thickness of the base 5 may be 0.7 mm or more, or 0.8 mm or more. The thickness of the base 5 may be 2.5 mm or less, or 2 mm or less.

The shape of the projecting strip portion 11 is not limited to a particular shape. As shown in FIG. 1, the projecting strip portion 11 extends, for example, linearly. The projecting strip portion 11 may extend in a wavelike manner or in a zig-zag manner. The shape of a cross-section perpendicular to the longitudinal direction of the projecting strip portion 11 is not limited to a particular shape. In the electromagnetic shield 1a, the shape of the cross-section is, for example, a quadrilateral. The shape of the cross-section may be a triangle, a polygon other than a triangle, a semicircle, or a semi ellipse.

As described above, the electromagnetic shield 1a includes a dielectric. A relative permittivity of the dielectric is not limited to a particular value. An imaginary part $\varepsilon''$ of the relative permittivity of the dielectric at at least one frequency $f_g$ in a range of 10 GHz to 300 GHz is, for example, 0.1 or less. It appears that the imaginary part $\varepsilon''$ of the dielectric is desirably large in the case of attenuating an electromagnetic wave using a dielectric loss. However, even if the imaginary part $\varepsilon''$ of the relative permittivity of the dielectric is as small as 0.1 or less, the electromagnetic shield 1a is likely to exhibit desired performance by adjusting a phenomenon caused by an interaction between the electromagnetic shield 1a and an electromagnetic wave. The imaginary part $\varepsilon''$ may be 0.07 or less, 0.05 or less, or 0.01 or less.

A real part $\varepsilon'$ of the relative permittivity of the dielectric included in the electromagnetic shield 1a is not limited to a particular value. For example, the real part $\varepsilon'$ of the relative permittivity of the dielectric at the frequency $f_g$ is 2.0 to 4.0. Even in this case, the electromagnetic shield 1a is likely to exhibit desired performance by adjusting a phenomenon caused by an interaction between the electromagnetic shield 1a and an electromagnetic wave. The real part $\varepsilon'$ may be 3.8 or less, 3.6 or less, 3.4 or less, 3.2 or less, 3.0 or less, 2.8 or less, 2.6 or less, or 2.4 or less. The real part $\varepsilon'$ is desirably 2.1 or more and 3.5 or less, more desirably 2.2 or more and 3.0 or less.

The electromagnetic shield 1a is, for example, free of an electrically conductive portion. For electromagnetic shielding, it is conceivable that, for example, an electrically conductive portion such as a metal film is used to reflect an electromagnetic wave. However, the electromagnetic shield 1a can block an electromagnetic wave without an electrically conductive portion. The electromagnetic shield 1a may consist of the dielectric. The electromagnetic shield 1a may include an electrically conductive portion.

The electromagnetic shield 1a is, for example, a resin molded article. In this case, the cost of manufacturing the electromagnetic shield 1a is likely to be low. The resin included in the resin molded article is not limited to a particular resin.

The resin is, for example, a thermoplastic resin. Examples of the resin include polyethylene, polypropylene, polyvinyl alcohol, polyethylene terephthalate, polybutylene terephthalate, ethylene-vinyl acetate copolymer, polystyrene, acrylonitrile styrene, acrylonitrile-butadiene-styrene copolymer, ASA resin, AES resin, acrylic resins such as PMMA, MS resin, MBS resin, cycloolefin resin, polyacetal resin, polyamide resin, polyester resin, polycarbonate resin, polyurethane resin, liquid crystal polymer, EPDM, PPS, PEEK, PPE, polysulfone-based resin, polyimide-based resin, fluorine resin, thermoplastic elastomers such as an olefin-based thermoplastic elastomer (TPO), and acrylic elastomers. The resin may be a thermosetting resin. The thermosetting resin is, for example, an epoxy resin, an acrylic resin, or a silicone resin. The resin molded article may include only one resin or two or more resins.

The electromagnetic shield 1a may include, for example, a filler. The filler may be a colorant such as carbon black, an inorganic reinforcement such as talc, glass fibers, or a mineral, or a softener. The electromagnetic shield 1a may include an additive such as a flame retardant or a plasticizer. The electromagnetic shield 1a may be free of a filler. In this case, the cost of manufacturing the electromagnetic shield 1a is likely to be low.

In the case where the electromagnetic shield 1a is a resin molded article, the method for molding the electromagnetic shield 1a is not limited to a particular method. The electromagnetic shield 1a can be manufactured by injection molding, press molding, blow molding, or vacuum molding.

An application of the electromagnetic shield 1a is not limited to a particular application. As shown in FIG. 3A, for example, a radar cover 30 including the electromagnetic shield 1a can be provided. A component that includes the electromagnetic shield 1a and that is other than a radar cover may be provided.

As shown in FIGS. 3A and 4, the radar cover 30 is, for example, in the shape of a hollow truncated pyramid, and has the first opening 32 and the second opening 34. Each of the first opening 32 and the second opening 34 is, for example, rectangular. The second opening 34 is bigger than the first opening 32. A portion, such as an antenna of a radar (not illustrated), of a radar is disposed in the first opening 32. An internal surface of the radar cover 30 is the first surface 10 of the electromagnetic shield 1a, and the projecting strip portions 11 are provided on the internal surface. On the other hand, an external surface of the radar cover 30 is the second surface 20 of the electromagnetic shield 1a.

Unnecessary radio waves incident on the internal surface of the radar cover 30 are attenuated by the electromagnetic shield 1a and transmitted in an attenuated state. This can consequently prevent a radar from receiving unnecessary radio waves.

In FIG. 3A, the arrow Z indicates the gravity direction. The radar cover 30 can be disposed as shown in FIG. 3A when used. In the radar cover 30, a side portion of the radar cover 30 is made of the electromagnetic shield 1a, and the space 15 is present on the first surface 10 side. Therefore, it is easy to drain water placed on the side portion of the radar cover 30 away through the space 15.

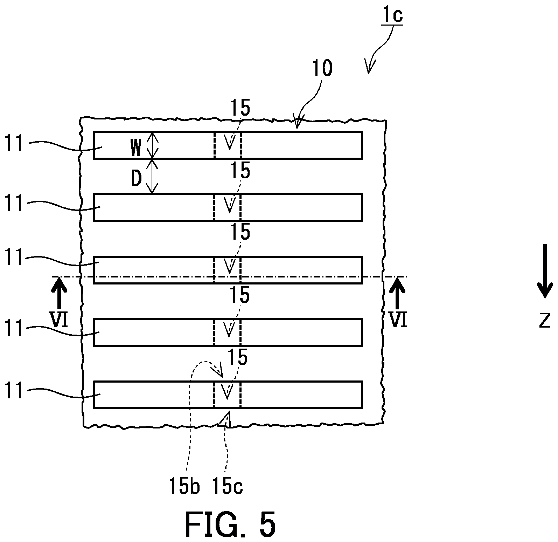

The electromagnetic shield 1a can be modified in various respects. For example, the electromagnetic shield 1a may be modified to an electromagnetic shield 1c as shown in FIG. 5. The electromagnetic shield 1c is configured in the same manner as the electromagnetic shield 1a unless otherwise described. The components of the electromagnetic shield 1c that are the same as or correspond to the components of the electromagnetic shield 1a are denoted by the same reference characters, and detailed descriptions of such components are omitted. The description given for the electromagnetic shield 1a applies to the electromagnetic shield 1c, unless there is technical inconsistency.

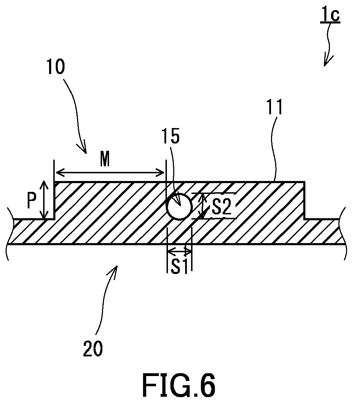

As shown in FIGS. 5 and 6, in the electromagnetic shield 1c, the space 15 forms a through hole in the projecting strip portion 11. In this case as well, the performance of the electromagnetic shield 1c is less likely to decrease because water placed near the projecting strip portion 11 is drained away through the space 15 and is thus less likely to stay near the projecting strip portion 11. Furthermore, since the space 15 is covered in the projection direction of the projecting strip portion 11, clogging of the space 15 by a flying foreign matter or the like is easily prevented.

In the electromagnetic shield 1c, a maximum dimension S1 of the through hole formed by the space 15 in the longitudinal direction of the projecting strip portion 11 and a maximum dimension S2 of the through hole formed by the space 15 in the projection direction of the projecting strip portion 11 are not limited to particular values. The maximum dimension S1 is, for example, 3 mm or more. In such a configuration, it is easier to drain water placed near the projecting strip portion 11 away through the space 15. The maximum dimension S1 is desirably 3.2 mm or more, more desirably 3.5 mm or more, even more desirably 4 mm or more. The maximum dimension S1 is, for example, 10 mm or less, and may be 9 mm or less, or 8 mm or less.

The maximum dimension S2 is, for example, 3 mm or more. In such a configuration, it is easier to drain water placed near the projecting strip portion 11 away through the space 15. The maximum dimension S2 is desirably 3.2 mm or more, more desirably 3.5 mm or more, even more desirably 4 mm or more. The maximum dimension S2 is, for example, 10 mm or less, and may be 9 mm or less, or 8 mm or less.

A distance M between a longitudinal end of the projecting strip portion 11 and the space 15 is not limited to a particular value. The distance M is, for example, 100 mm or less. In such a configuration, a distance that water placed near the projecting strip portion 11 travels to be led to the space 15 tends to be shorter, and water placed near the projecting strip portion 11 is likely to drain away in a short period of time.

The distance M may be 90 mm or less, or 80 mm or less. The distance M is, for example 5 mm or more, and may be 10 mm or more, or 15 mm or more. The distance M may be 100 mm or more.

In the electromagnetic shields 1a, 1b, and 1c, an interaction occurring between the electromagnetic shield and an electromagnetic wave for blocking of the electromagnetic wave is not limited to a particular interaction. Each of the electromagnetic shields 1a, 1b, and 1c, for example, transmits at least a portion of an electromagnetic wave incident on the first surface 11 and allows a scattered electromagnetic wave to emerge from the second surface 12. In other words, each of the electromagnetic shields 1a, 1b, and 1c can function as a radio-wave transmitting-scattering body. Electromagnetic shielding can therefore be achieved with a simple configuration.

Each of the electromagnetic shields 1a, 1b, and 1c has a scattering ratio of, for example, 0.1% or more. The term "scattering ratio" refers to a ratio of an intensity of a particular transmitted-scattered wave to an intensity of a straight transmitted wave emerging from the second surface 20, the intensities being measured when a radio wave is perpendicularly incident on the first surface 10. The scattering ratio is determined, for example, by the following equation (1). In the equation (1), "Intensity of transmitted-scattered wave" is, for example, a sum of intensities measured for a transmitted-scattered wave at scattering angles of 15°, 30°, 45°, 60°, and 75°. The term "scattering angle" refers to an angle between an emergent direction of a straight transmitted wave and an emergent direction of a transmitted-scattered wave.

Scattering ratio=Intensity of transmitted-scattered wave/Intensity of straight transmitted wave

The intensity of the transmitted-scattered wave and the intensity of the straight transmitted wave can be determined with reference to Japanese Industrial Standards (JIS) R 1679: 2007, for example, by allowing a radio wave to be perpendicularly incident on the first surface 10 and measuring a transmission attenuation in a straight direction and a transmission attenuation at a given scattering angle. Each transmission attenuation is expressed by the following equation (2). In the equation (2), $P_i$ is a received electric power, and $P_0$ is a transmitted electric power. $|P_i/P_0|$ corresponds to the intensity of a transmitted wave. "Log" represents a common logarithm.

$$\text{Transmission attenuation} = |10\text{Log}(P_i/P_0)| \qquad \text{Equation (2)}$$

The scattering ratio of each of the electromagnetic shields 1a, 1b, and 1c may be 1% or more, 5% or more, 10% or more, 20% or more, 50% or more, 100% or more, 150% or more, or 200% or more.

A structure of each of the electromagnetic shields 1a, 1b, and 1c on the first surface 10 side with the projecting strip portion 11 is thought to function, for example, as a diffraction grating. Regarding light diffraction, a zero-order light transmittance $I_0$ through a diffraction grating having a rectangular cross-section is expressed by the following equation (3) in accordance with a scalar diffraction theory. In the equation (3), $\varepsilon_r$ is the real part of the relative permittivity of the material of the diffraction grating, and sqrt($\varepsilon_r$) is a square root of $\varepsilon_r$. The symbol h is a height of a protruding portion of the diffraction grating. The symbol λ is the wavelength of light.

$$I_0 = \cos^2(\pi \cdot |sqrt(\varepsilon_r)| - 1 \cdot (h/\lambda)) \quad \text{Equation (3)}$$

According to Bragg's law, a direction (scattering angle) of a scattered-transmitted wave generated by diffraction is determined by a pitch of protruding portions of a diffraction grating. Constructive interference and destructive interference between diffraction waves having passed between the protruding portions generate an interference fringe. It is thought that in this case, a transmitted-scattered wave is observed as a result of constructive interference between diffraction waves. Constructive interference between diffraction waves can be expressed by an equation (4), while destructive interference between diffraction waves can be expressed by an equation (5). In the equations (4) and (5), d is a pitch of protruding portions of a diffraction grating, $\theta$ is an angle at which constructive interference or destructive interference between diffraction waves occurs, m is an integer of 0 or greater, and $\lambda$ is the wavelength of an incident wave. It is understood that when $\lambda$ is constant, the scattering angle of a transmitted-scattered wave can vary depending on the pitch of the protruding portions of the diffraction grating. Table 1 shows an example of a relation between the scattering angle $\theta$ at which constructive interference between diffraction waves occurs and the pitch d.

$$dsin\theta = m\lambda \quad \text{Equation (4)}$$

$$dsin\theta = (m + 1/2)\lambda \quad \text{Equation (5)}$$

[Table 1]

| Scattering angle $\theta$ | | Interference | Pitch d [mm] of protruding portions of diffraction grating | | | | | | | | |
|---|---|---|---|---|---|---|---|---|---|---|---|
| | | | 4 | 5 | 6 | 7 | 8 | 9 | 10 | 11 | 12 |
| Order of diffraction m | 0 | Constructive | 0° | 0° | 0° | 0° | 0° | 0° | 0° | 0° | 0° |
| | 0 | Destructive | 29° | 23° | 19° | 16° | 14° | 13° | 11° | 10° | 9° |
| | 1 | Constructive | 79° | 52° | 41° | 34° | 29° | 26° | 23° | 21° | 19° |
| | 1 | Destructive | - | - | 79° | 57° | 47° | 41° | 36° | 32° | 29° |
| | 2 | Constructive | - | - | - | - | 79° | 61° | 52° | 45° | 41° |
| | 2 | Destructive | - | - | - | - | - | - | 79° | 63° | 55° |
| | 3 | Constructive | - | - | - | - | - | - | - | - | 79° |

EXAMPLES

The present invention will be described hereinafter in more details by examples. The present invention is not limited to the examples given below. First, evaluation methods for the examples will be described.

[Transmission attenuation]

A radio wave having a frequency of 76.5 GHz or 24 GHz was allowed to be incident on a first surface of each sample to measure a transmission attenuation in a straight direction of the radio wave using a radio transceiver EAS02 manufactured by KEYCOM Corporation with reference to JIS R 1679: 2007. A radar device manufactured by SHARP TAKAYA ELECTRONICS INDUSTRY CO., LTD. was used to generate the radio wave having a frequency of 24 GHz. In the measurement using the radio wave having a frequency of 76.5 GHz, a measurement region had a diameter of 30 mm. The transmission attenuation was determined by the above equation (2). Tables 2 and 3 show the results.

[Drainage performance]

In a state where a projection direction and a longitudinal direction of projecting strips were horizontal and a plate-shaped base of the sample was disposed to be perpendicular to a horizontal plane, 2 cm$^3$ of water was dropped to a side of a topmost projecting strip of the sample, and the time required for 30% or more of the water on a volume basis to drain away through a through hole or a gap was measured. In the case of a sample having a through hole or a

gap, the 2 cm$^3$ of water was dropped to a through hole or a gap in contact with the topmost projecting strip. If the water stayed on the side of the projecting strip, in the through hole, or in the gap and did not drain away, the drainage performance of the sample was evaluated as "Not Good". Tables 2 and 3 show the results.

<Sample 1A>

A plate-shaped resin molded article having two principal surfaces was obtained by molding an olefin-based thermoplastic elastomer (TPO). One of the principal surfaces had six linearly-extending projecting strips projecting from a flat-plate-shaped base, and the other principal surface was flat. A sample 1A was obtained in this manner. The real part $\varepsilon'$ of the complex relative permittivity of the olefin-based thermoplastic elastomer at a frequency of 76.5 GHz was 2.43. In the sample 1A, the one principal surface having the six projecting strips was formed as the first surface, while the other principal surface was formed as the second surface. The projecting strips were disposed parallel to each other and were in a row in a direction perpendicular to a longitudinal direction of the projecting strip. A distance between the projecting strips in the direction perpendicular to the longitudinal direction of the projecting strip was 6 mm. Each projecting strip had a projection length of 4 mm, a length of 50 mm in the longitudinal direction, and a width of 2 mm. A cross-section of the projecting strip was rectangular, the cross-section being perpendicular to the longitudinal direction of the projecting strip.
A through hole having a diameter of 4 mm was provided in each projecting strip of the sample 1A. A cross-section of the through hole was circular. A distance between one longitudinal end of the projecting strip and the through hole was 23 mm, and a distance between the other longitudinal end of the projecting strip and the through hole was 23 mm. The six through holes in the six projecting strips were arranged on a straight line in the direction perpendicular to the longitudinal direction of the projecting strip.

<Sample 1B>

A sample 1B was produced in the same manner as the sample 1A, except that no through holes were formed in each projecting strip.

<Sample 2A>

A sample 2A was produced in the same manner as the sample 1A, except that the distance between the projecting strips in the direction perpendicular to the longitudinal direction of the projecting strip was changed to 8 mm and the number of projecting strips was changed to five.

<Sample 2B>

A sample 2B was produced in the same manner as the sample 2A, except that no through holes were formed in each projecting strip.

<Sample 3A-1>

A sample 3A-1 was produced in the same manner as the sample 1A, except for the following points. In the sample 3A-1, the distance between the projecting strips in the direction perpendicular to the longitudinal direction of the projecting strip was 4 mm. A pair of the projecting strips were arranged in the longitudinal direction of the projecting strip, and a gap, instead of a through hole, was provided between the paired projecting strips. Eight such pairs of the projecting strips were arranged such that the projecting strips were in two rows in the direction perpendicular to the longitudinal direction of the projecting strip, and gaps were provided between the rows of the projecting strips. A width of the gap in the longitudinal direction of the projecting strip was 2 mm. The shape of a cross-section of the projecting strip along the longitudinal direction of the projecting strip was rectangular. A length of each pair of the projecting strip in the longitudinal direction of the projecting strip was 50 mm. The gaps were arranged on a straight line in the direction perpendicular to the longitudinal direction of the projecting strip.

<Sample 3A-2>

A sample 3A-2 was produced in the same manner as the sample 3A-1, except that the width of the gap in the longitudinal direction of the projecting strip was changed to 3 mm.

<Sample 3A-3>

A sample 3A-3 was produced in the same manner as the sample 3A-1, except that the width of the gap in the longitudinal direction of the projecting strip was changed to 4 mm.

<Sample 3A-4>

A sample 3A-4 was produced in the same manner as the sample 1A, except that the distance between the projecting strips in the direction perpendicular to the longitudinal direction of the projecting strip was changed to 4 mm and the diameter of the through hole was changed to 5 mm.

<Sample 3B-1>

A sample 3B-1 was produced in the same manner as the sample 3A-4, except that no through holes were formed.

<Sample 3B-2>

A sample 3B-2 was produced in the same manner as the sample 3A-4, except that the diameter of the through hole was changed to 4 mm.

<Sample 3B-3>

A sample 3B-3 was produced in the same manner as the sample 3A-1, except that the width of the gap in the longitudinal direction of the projecting strip was changed to 1 mm.

<Sample 4A-1>

A sample 4A-1 was produced in the same manner as the sample 1A, except for the following points. In the sample 4A-1, three projecting strips were arranged parallel to each other and were in a row in the direction perpendicular to the longitudinal direction of the projecting strip. A distance between the projecting strips in the direction perpendicular to the longitudinal direction of the projecting strip was 12 mm. Each projecting strip had a projection length of 12 mm, a length of 150 mm in the longitudinal direction, and a width of 12 mm. A cross-section of the projecting strip was square, the cross-section being perpendicular to the longitudinal direction of the projecting strip.

A through hole having a diameter of 4 mm was provided in each projecting strip of the sample 4A-1. A cross-section of the through hole was circular. A distance between one longitudinal end of the projecting strip and the through hole was 73 mm, and a distance between the other longitudinal end of the projecting strip and the through hole was 73 mm. The three through holes in the three projecting strips were arranged on a straight line in the direction perpendicular to the longitudinal direction of the projecting strip.

<Sample 4A-2>

A sample 4A-2 was produced in the same manner as the sample 4A-1, except for the following points. In the sample 4A-2, the distance between the projecting strips in the direction perpendicular to the longitudinal direction of the projecting strip was 12 mm. A pair of the projecting strips were arranged in the longitudinal direction of the projecting strip, and a gap, instead of a through hole, was provided between the paired projecting strips. Three such pairs of the projecting strips were arranged such that the projecting strips were in two rows in the direction perpendicular to the longitudinal direction of the projecting strip, and three gaps were provided between the rows of the projecting strips. The width of the gap in the longitudinal direction of the projecting strip was 2 mm. The shape of a cross-section of the projecting strip along the longitudinal direction of the projecting strip was rectangular. The length of each pair of the projecting strip in the longitudinal direction of the projecting strip was 150 mm. The gaps were arranged on a straight line in the direction perpendicular to the longitudinal direction of the projecting strip.

<Sample 4A-3>

A sample 4A-3 was produced in the same manner as the sample 4A-1, except that the diameter of the through hole was changed to 6 mm.

<Sample 4A-4>

A sample 4A-4 was produced in the same manner as the sample 4A-2, except that the width of the gap in the longitudinal direction of the projecting strip was changed to 10 mm.

<Sample 4A-5>

A sample 4A-5 was produced in the same manner as the sample 4A-1, except that the diameter of the through hole was changed to 8 mm.

<Sample 4A-6>

A sample 4A-6 was produced in the same manner as the sample 4A-2, except that the width of the gap in the longitudinal direction of the projecting strip was changed to 12 mm.

<Sample 4B-1>

A sample 4B-1 was produced in the same manner as the sample 4A-1, except that no through holes were formed.

<Sample 4B-2>

A sample 4B-2 was produced in the same manner as the sample 4A-1, except that the diameter of the through hole was changed to 2 mm.

<Sample 4B-3>

A sample 4B-3 was produced in the same manner as the sample 4A-2, except that the width of the gap in the longitudinal direction of the projecting strip was changed to 1 mm.

As shown in Tables 2 and 3, the drainage time was eight seconds or shorter for the samples 1A, 2A, 3A-1 to 3A-4, and 4A-1 to 4A-6, which means that these samples exhibited good drainage performance. On the other hand, the samples 1B, 2B, 3B-1, 3B-3, and 4B-1 failed in drainage. For the samples 3B-2, 4B-2, and 4B-3, drainage was able to be accomplished although the drainage time was longer than eight seconds.

[Table 2]

| Sample No. | Projecting strip | | | Space | | Drainage performance | Transmission attenuation in straight direction 76.5 GHz (dB) |
| | Width [mm] | Projection length [mm] | Distance between projecting strips [mm] | Type | Dimension [mm] | | |
|---|---|---|---|---|---|---|---|
| 1A | 2 | 4 | 6 mm | Through hole | 4 | 5 sec | 12 |
| 1B | 2 | 4 | 6 mm | N/A | - | Not Good | 13 |
| 2A | 2 | 4 | 8 mm | Through hole | 4 | 4 sec | 7 |
| 2B | 2 | 4 | 8 mm | N/A | - | Not Good | 8 |
| 3A-1 | 2 | 4 | 4 mm | Gap | 2 | 6 sec | 25 |
| 3A-2 | 2 | 4 | 4 mm | Gap | 3 | 2 sec | 26 |
| 3A-3 | 2 | 4 | 4 mm | Gap | 4 | 1 sec | 16 |
| 3A-4 | 2 | 4 | 4 mm | Through hole | 5 | 8 sec | 16 |
| 3B-1 | 2 | 4 | 4 mm | N/A | - | Not Good | 24 |
| 3B-2 | 2 | 4 | 4 mm | Through hole | 4 | 9 sec or longer | 17 |
| 3B-3 | 2 | 4 | 4 mm | Gap | 1 | Not Good | 25 |

[Table 3]

| Sample No. | Projecting strip | | | Space | | Drainage performance | Transmission attenuation in straight direction 24 GHz (dB) |
| | Width [mm] | Projection length [mm] | Distance between projecting strips [mm] | Type | Dimension [mm] | | |
|---|---|---|---|---|---|---|---|
| 4A-1 | 12 | 12 | 12 | Through hole | 4 | 3 sec | 13.1 |
| 4A-2 | 12 | 12 | 12 | Gap | 2 | 7 sec | 13.1 |
| 4A-3 | 12 | 12 | 12 | Through hole | 6 | 1 sec | 10.7 |
| 4A-4 | 12 | 12 | 12 | Gap | 10 | 1 sec | 10.2 |
| 4A-5 | 12 | 12 | 12 | Through hole | 8 | 1 sec | 8.6 |
| 4A-6 | 12 | 12 | 12 | Gap | 12 | 1 sec | 9.9 |
| 4B-1 | 12 | 12 | 12 | N/A | - | Not Good | 13.3 |
| 4B-2 | 12 | 12 | 12 | Through hole | 2 | 9 sec or longer | 13.6 |
| 4B-3 | 12 | 12 | 12 | Gap | 1 | 9 sec or longer | 13.4 |

**Claims**

1. An electromagnetic shield comprising:

   a plate-shaped base having a first surface and a second surface, the first surface being configured to allow an electromagnetic wave to be incident on the first surface, the second surface being distant from the first surface and extending along the first surface; and
   projecting strip portions projecting from the first surface in a direction away from the second surface, wherein the electromagnetic shield includes a dielectric,
   the electromagnetic shield has a space forming either a gap or a hole, and
   the gap or the hole is in contact with the projecting strip portion along a direction intersecting with a longitudinal direction of the projecting strip portion.

2. The electromagnetic shield according to claim 1, wherein the space has an opening at an end portion of the space in a projecting direction of the projecting strip portion.

3. The electromagnetic shield according to claim 1, wherein

   the projecting strip portions include a pair of projecting strip portions arranged in the longitudinal direction of the projecting strip portion, and
   the space is present between the pair of projecting strip portions.

4. The electromagnetic shield according to claim 2 or 3, wherein a maximum dimension of the space in the longitudinal direction of the projecting strip portion is more than 1 mm.

5. The electromagnetic shield according to claim 1, wherein the space forms a through hole in the projecting strip portion.

6. The electromagnetic shield according to claim 5, wherein a maximum dimension of the through hole in the longitudinal direction of the projecting strip portion is 3 mm or more.

7. The electromagnetic shield according to claim 5 or 6, wherein a maximum dimension of the through hole in a projecting direction of the projecting strip portion is 3 mm or more.

8. The electromagnetic shield according to any one of claims 1 to 7, wherein when the electromagnetic shield is disposed such that the projecting strip portion projects in a horizontal direction and extends along the horizontal direction, one end of the space is positioned above the other end of the space.

9. The electromagnetic shield according to any one of claims 1 to 8, wherein

the electromagnetic shield comprises a plurality of the projecting strip portions arranged parallel to each other,
the electromagnetic shield has a plurality of the spaces, and
each of the projecting strip portions is in contact with at least one of the spaces.

10. The electromagnetic shield according to claim 9, wherein a distance between the projecting strip portions adjacent to each other in a direction perpendicular to the longitudinal direction of the projecting strip portion is greater than a dimension of the space in the longitudinal direction of the projecting strip portion.

11. The electromagnetic shield according to claim 9 or 10, wherein the spaces are arranged on a straight line.

12. The electromagnetic shield according to any one of claims 1 to 11, wherein

at least one selected from the group consisting of the electromagnetic shield and the base is a ring-shaped body and has a polygonal or circular outer perimeter when the first surface is viewed along an axis of the ring-shaped body,
the electromagnetic shield further includes a contact portion configured to be in contact with a component other than the electromagnetic shield, and
the contact portion abuts on the outer perimeter.

13. The electromagnetic shield according to claim 12, wherein

at least one selected from the group consisting of the electromagnetic shield and the base is a hollow body whose outer shape is a truncated pyramidal shape, a truncated conical shape, or a truncated elliptical conical shape and which has an opening in each of positions in the outer shape, the positions corresponding to an upper base and a lower base of a truncated pyramid, a truncated cone, or a truncated elliptic cone,
the first surface is an inner surface of the hollow body being the electromagnetic shield or the base, and
the second surface is an outer surface of the hollow body being the electromagnetic shield or the base.

14. The electromagnetic shield according to claim 13, wherein the projecting strip portions project in a direction perpendicular to the lower base.

15. The electromagnetic shield according to any one of claims 1 to 14, wherein the electromagnetic shield is free of an electrically conductive portion.

16. The electromagnetic shield according to any one of claims 1 to 15, wherein an imaginary part $\varepsilon''$ of a relative permittivity of the dielectric at at least one frequency in a range of 10 GHz to 300 GHz is 0.1 or less.

17. The electromagnetic shield according to any one of claims 1 to 16, wherein a real part $\varepsilon'$ of a relative permittivity of the dielectric at at least one frequency in a range of 10 GHz to 300 GHz is 2.0 to 4.0.

18. The electromagnetic shield according to any one of claims 1 to 17, wherein

the electromagnetic shield is capable of shielding against an electromagnetic wave with a wavelength $\lambda$, and
a projection length P of at least one of the projecting strip portions satisfies a requirement $0.25\lambda \leq P \leq 1.3\lambda$.

19. The electromagnetic shield according to any one of claims 1 to 18, wherein

the electromagnetic shield is capable of shielding against an electromagnetic wave with a wavelength $\lambda$, and
a width W of at least one of the projecting strip portions satisfies a requirement $0.51\lambda \leq W \leq 1.6\lambda$.

20. The electromagnetic shield according to any one of claims 1 to 19, wherein

the electromagnetic shield is capable of shielding against an electromagnetic wave with a wavelength $\lambda$, and
a distance D between the projecting strip portions satisfies a requirement $0.51\lambda \leq D \leq 1.6\lambda$.

21. A radar cover comprising the electromagnetic shield according to any one of claims 1 to 20.

FIG. 1

FIG.2

FIG. 3A

FIG. 3B

FIG.4

FIG. 5

FIG.6

## INTERNATIONAL SEARCH REPORT

| International application No. |
|---|
| **PCT/JP2022/028280** |

### A. CLASSIFICATION OF SUBJECT MATTER

***G01S 7/03***(2006.01)i; ***H05K 9/00***(2006.01)i
FI:  G01S7/03 246; H05K9/00 M

According to International Patent Classification (IPC) or to both national classification and IPC

### B. FIELDS SEARCHED

Minimum documentation searched (classification system followed by classification symbols)

G01S7/00-7/42, 13/00-13/95; H05K9/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2019/132027 A1 (NITTO DENKO CORPORATION) 04 July 2019 (2019-07-04) paragraphs [0002], [0014]-[0096], fig. 1-8 | 1-4, 8-11 |
| Y | paragraphs [0002], [0014]-[0096], fig. 1-8 | 12-21 |
| A | paragraphs [0002], [0014]-[0096], fig. 1-8 | 5-7 |
| Y | WO 2021/010483 A1 (KOITO MANUFACTURING CO., LTD.) 21 January 2021 (2021-01-21) paragraphs [0073]-[0075], fig. 10, 11 | 12-21 |
| Y | JP 2003-283242 A (MURATA MFG CO LTD) 03 October 2003 (2003-10-03) paragraph [0022] | 15-21 |
| A | JP 2006-078665 A (NIPPON ZEON CO LTD) 23 March 2006 (2006-03-23) entire text, all drawings | 1-21 |
| A | JP 2020-150221 A (NITTO DENKO CORPORATION) 17 September 2020 (2020-09-17) entire text, all drawings | 1-21 |

☑ Further documents are listed in the continuation of Box C.   ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 August 2022** | **13 September 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2022/028280**

C.      DOCUMENTS CONSIDERED TO BE RELEVANT

| Category* | Citation of document, with indication, where appropriate, of the relevant passages | Relevant to claim No. |
|---|---|---|
| A | JP 8-274492 A (FUJI ELELCTROCHEM CO LTD) 18 October 1996 (1996-10-18)<br>entire text, all drawings | 1-21 |
| A | JP 2020-57759 A (TOYO INK SC HOLDINGS CO LTD) 09 April 2020 (2020-04-09)<br>entire text, all drawings | 1-21 |
| A | JP 2020-60506 A (HITACHI AUTOMOTIVE SYSTEMS LTD) 16 April 2020 (2020-04-16)<br>entire text, all drawings | 1-21 |

Form PCT/ISA/210 (second sheet) (January 2015)

## INTERNATIONAL SEARCH REPORT
### Information on patent family members

International application No.

**PCT/JP2022/028280**

| Patent document cited in search report | | | Publication date (day/month/year) | Patent family member(s) | | Publication date (day/month/year) |
|---|---|---|---|---|---|---|
| WO | 2019/132027 | A1 | 04 July 2019 | US 2021/0059085 A1 paragraphs [0002], [0040]-[0123], fig. 1-8 EP 3735119 A1 KR 10-2020-0102431 A CN 111557129 A TW 201933980 A | | |
| WO | 2021/010483 | A1 | 21 January 2021 | EP 4001016 A1 paragraphs [0080]-[0083], fig. 10, 11 CN 212737941 U | | |
| JP | 2003-283242 | A | 03 October 2003 | US 2003/0179142 A1 paragraph [0033] DE 10313353 A1 FR 2839208 A1 | | |
| JP | 2006-078665 | A | 23 March 2006 | US 2008/0117509 A1 entire text, all drawings WO 2006/004010 A1 EP 1767965 A1 KR 10-2007-0041540 A | | |
| JP | 2020-150221 | A | 17 September 2020 | US 2022/0159884 A1 entire text, all drawings WO 2020/189350 A1 CN 113557802 A | | |
| JP | 8-274492 | A | 18 October 1996 | (Family: none) | | |
| JP | 2020-57759 | A | 09 April 2020 | (Family: none) | | |
| JP | 2020-60506 | A | 16 April 2020 | WO 2020/075422 A1 entire text, all drawings DE 112019004404 T5 | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004153135 A
- JP 5696781 B
- US 10074907 B2
- WO 2021058450 A1